# EUROPEAN PATENT APPLICATION

(11) **EP 4 657 755 A1**
(43) Date of publication of application: **03.12.2025**
(21) Application number: 25179817.9
(22) Date of filing: 30.05.2025
(51) Int. Cl.: H03K 3/84, H03L 7/18, H04B 1/713, H04B 1/69

(54) **CLOCK CIRCUIT AND RELATED METHOD IMPROVING FREQUENCY HOPPING**

(30) Priority: 31.05.2024 TW 113120388
(71) Applicant: M31 Technology Corporation, Zhubei City Hsinchu 302082 (TW)
(72) Inventor: HUANG, Hsiang-En, 302 Zhubei City, Hsinchu County (TW); HUANG, Yen-Yin, 302 Zhubei City, Hsinchu County (TW)
(74) Representative: Krauns, Christian

(57) **Abstract**

The present disclosure provides a clock circuit and related method improving frequency hopping. The clock circuit may comprise a frequency divider and a frequency hopping circuit. The frequency divider may perform a frequency division according to a first divisor number. When hopping to a frequency or a spread spectrum range which is corresponding to an input number, if a convergence condition is not satisfied, the frequency hopping circuit may perform a stepping operation to update the first divisor number from a previous value to a current value which may not equal the input number.

## Description

### TECHNICAL FIELD

The present disclosure relates to a clock circuit and related method improving frequency hopping, more particularly, to a clock circuit and related method involving a frequency divider and a frequency hopping circuit, wherein the frequency divider may perform a frequency division according to a first divisor number, and the clock circuit may provide a clock according to a result of the frequency division performed by the frequency divider; when the clock circuit is requested to cause a frequency of the clock to hop from a first frequency (or a first spread spectrum range) to a second frequency (or a second spread spectrum range), the clock circuit may stabilize the frequency of the clock to the second frequency (or the second spread spectrum range) after an interval; during the interval, the frequency hopping circuit may stepwise change the first divisor number, such that the clock circuit may accomplish the frequency hopping without the need to relock timing (frequency and/or phase) of the clock.

### BACKGROUND

A clock circuit can provide one or more periodical clocks and/or signals, and is an essential building block of various kinds of integrated circuits.

### SUMMARY

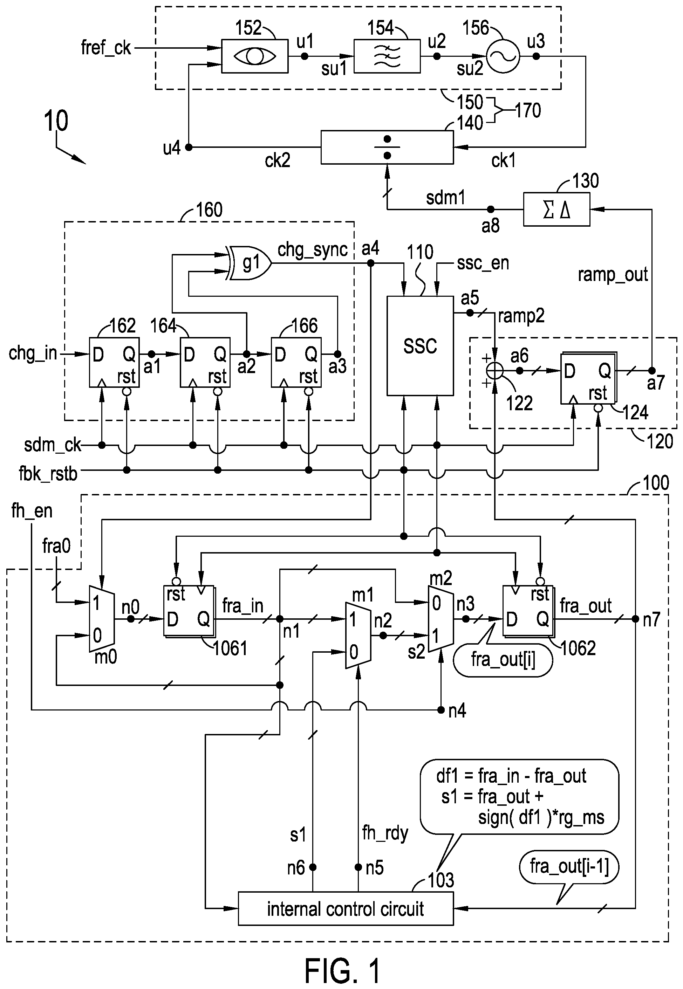

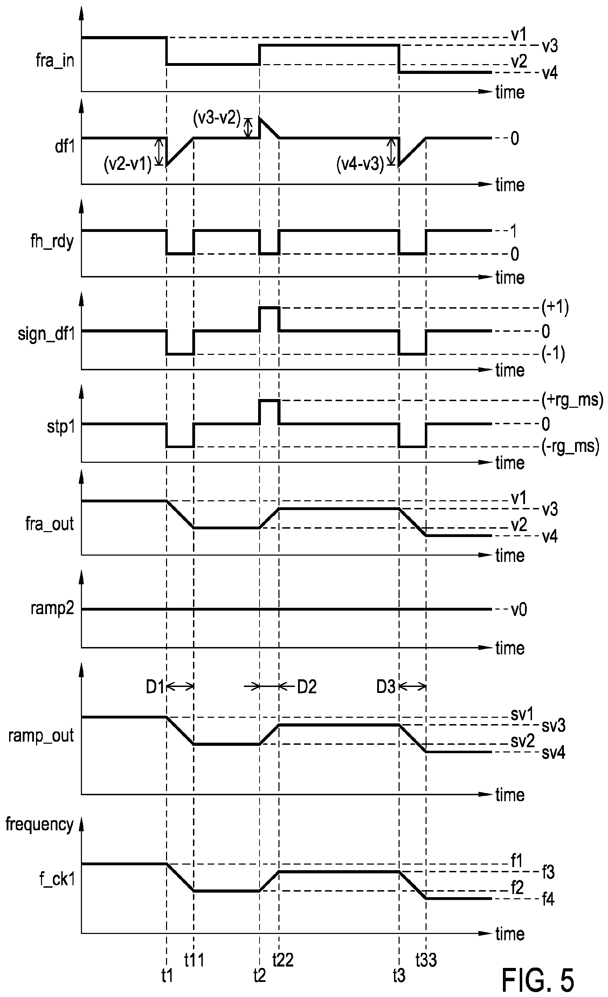

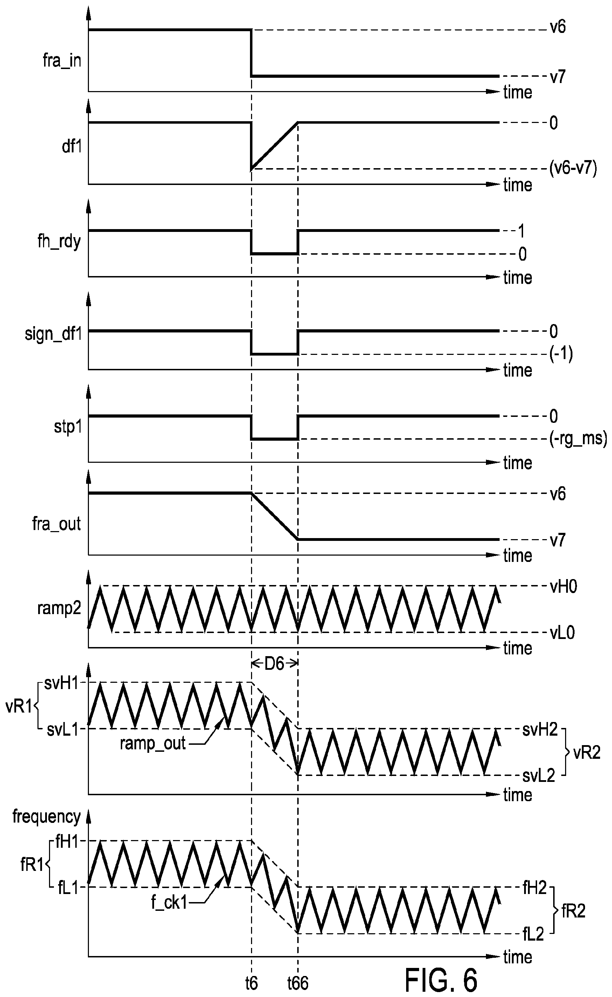

The clock circuit of the present disclosure not only may provide one or more clocks (e.g., ck1 in FIG. 1), but also may implement a frequency hopping function and/or a spread spectrum function for the clock(s), and may therefore satisfy a variety of demands which a modern integrated circuit may require. For a clock, the spread spectrum function may cause a frequency of the clock to vary in a spread spectrum range, e.g., may cause the frequency of the clock to periodically vary between an upper bound frequency and a lower bound frequency. Regarding the frequency hopping function for a clock, the clock circuit of the present disclosure may implement a normal frequency hopping and a spread spectrum frequency hopping for the clock. For a clock, the normal frequency hopping (e.g., FIG. 5) may cause a frequency (e.g., f_ck1 in FIG. 5) of the clock to hop from a first frequency (e.g., f1 in FIG. 5) to a second frequency (e.g., f2 in FIG. 5) when the spread spectrum function is not performed on the clock, and the spread spectrum frequency hopping (e.g., FIG. 6) may cause the frequency (e.g., f_ck1 in FIG. 6) of the clock to hop from a first spread spectrum range (e.g., fR1 in FIG. 6) to a second spread spectrum range (e.g., fR2 in FIG 6) when the spread spectrum function is performed on the clock.

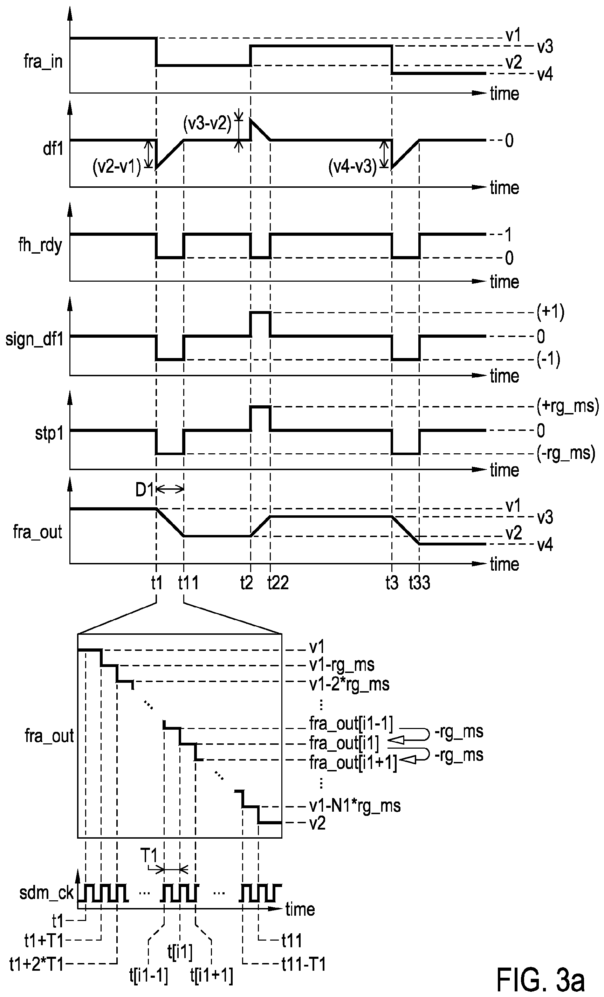

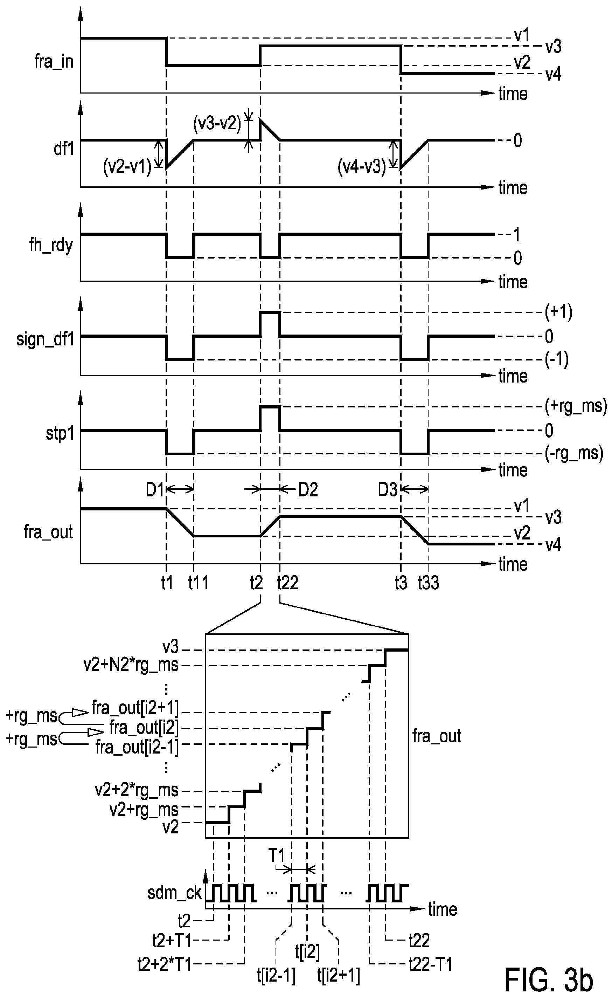

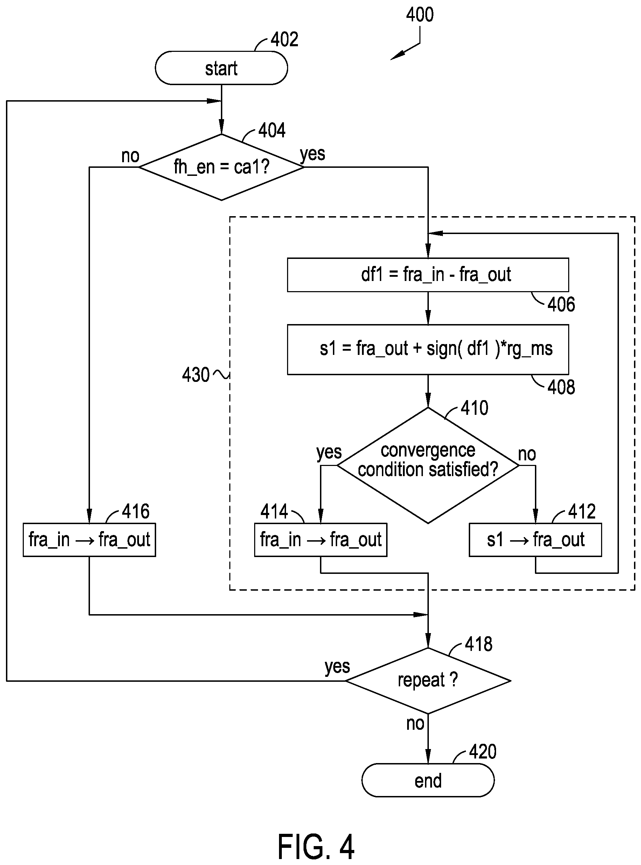

An object of the present disclosure is providing a clock circuit (e.g., 10 in FIG. 1) improving frequency hopping. The clock circuit may comprise a frequency divider (e.g., 140 in FIG. 1) and a frequency hopping circuit (e.g., 100 in FIG. 1). The frequency divider may perform a frequency division according to a first divisor number (e.g., fra_out in FIG. 1). The frequency hopping circuit may be coupled to the frequency divider, and may provide the first divisor number. When hopping to a frequency or a spread spectrum range corresponding to an input number (e.g., fra_in in FIG. 1, FIG. 3a or FIG. 3b), if a convergence condition (e.g., at step 410 in FIG. 4) is not satisfied, the frequency hopping circuit may perform a stepping operation (e.g., at step 412 in FIG. 4) to update the first divisor number from a previous value (e.g., fra_out[i-1], fra_out[i1-1] or fra_out[i2-1] in FIG. 1, FIG. 3a or FIG. 3b) to a current value (e.g., fra_out[i], fra_out[i1] or fra_out[i2] in FIG. 1, FIG. 3a or FIG. 3b) which may not equal the input number.

In an embodiment (e.g., FIG. 4), if the convergence condition is satisfied, the frequency hopping circuit may cause the first divisor number to equal the input number (e.g., at step 414 in FIG. 4).

In an embodiment (e.g., FIG. 4), the frequency hopping circuit may further perform a calculation operation (e.g., at step 406) and a decision operation (e.g., at step 410) before performing the stepping operation, and may iterate the calculation operation and the decision operation after performing the stepping operation. When the frequency hopping circuit performs the calculation operation, the frequency hopping circuit may calculate a difference number (e.g., df1) between the input number and the first divisor number. When the frequency hopping circuit performs the decision operation, the frequency hopping circuit may determine whether the convergence condition is satisfied. Whether the convergence condition is satisfied may relate to whether a number of times that a historical trend of a sign of the difference number shows a limit cycle during past iterations of the calculation operation.

In an embodiment (e.g., FIG. 4), whether the convergence condition is satisfied may relate to whether an absolute difference between the input number and the first divisor number is less than a threshold value.

In an embodiment, each of the first divisor number and the threshold value may be a non-integer value, the frequency hopping circuit may represent the first divisor number and the threshold value by two binary values of a same number of bits, wherein a least significant bit of the binary value which represents the threshold value may equal one, and remaining bits of the binary value which represents the threshold value may equal zero.

In an embodiment (e.g., FIG. 1 and FIG. 4), the frequency hopping circuit may be further coupled to a hopping enabling signal (e.g., fh_en in FIG. 1 and FIG. 4), and the frequency hopping circuit may perform the stepping operation if the hopping enabling signal equals a predefined logic value (e.g., ca1 in FIG. 4) and the convergence condition is not satisfied.

In an embodiment (e.g., FIG. 1 and FIG. 4), if the hopping enabling signal does not equal the predefined logic value, the frequency hopping circuit may cause the first divisor number to equal the input number (e.g., at step 416 in FIG. 4).

In an embodiment (e.g., FIG. 3a and FIG. 3b), when the frequency hopping circuit performs the stepping operation to update the first divisor number from the previous value (e.g., fra_out[i1-1] or fra_out[i2-1] in FIG. 3a or FIG. 3b) to the current value (e.g., fra_out[i1] or fra_out[i2] in FIG. 3a or FIG. 3b), if the input number is less than the previous value (e.g., fra_out[i1-1] in FIG. 3a), the frequency hopping circuit may cause the current value (e.g., fra_out[i1] in FIG. 3a) to equal the previous value (e.g., fra_out[i1-1] in FIG. 3a) minus a step value (e.g., rg_ms in FIG. 3a); if the input number is greater than the previous value (e.g., fra_out[i2-1] in FIG. 3b), the frequency hopping circuit may cause the current value (e.g., fra_out[i2] in FIG. 3b) to equal the previous value (e.g., fra_out[i2-1] in FIG. 3b) plus the step value (e.g., rg_ms in FIG. 3b). The step value may be a predetermined positive value.

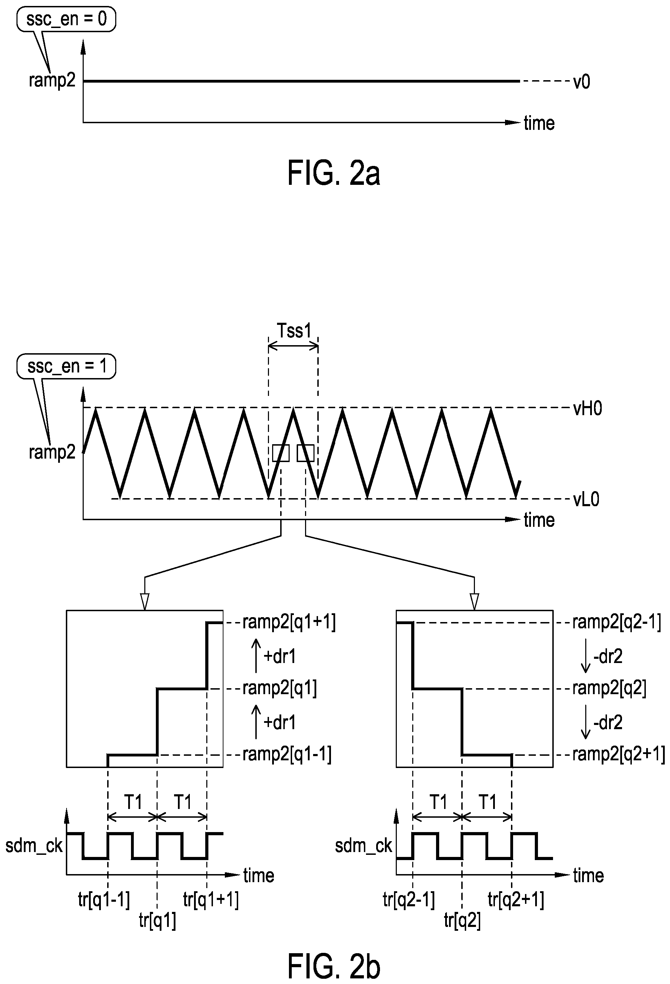

In an embodiment (e.g., FIG. 1, FIG. 3a, FIG. 3b and FIG. 4), the frequency hopping circuit may perform the stepping operation during a period (e.g., T1 in FIG. 3a and FIG. 3b) of an internal clock (e.g., sdm_ck in FIG. 1, FIG. 3a and FIG. 3b). When the frequency divider performs the frequency division according to the first divisor number, the frequency divider may perform the frequency division according to a sum of the first divisor number and a second divisor number (e.g., ramp2 in FIG. 1, FIG. 2b and FIG. 6). The second divisor number may periodically vary between a lower bound value (e.g., vL0 in FIG. 2b and FIG. 6) and an upper bound value (e.g., vH0 in FIG. 2b and FIG. 6), and a period (e.g., Tss1 in FIG. 2b) during which the second divisor number varies may be longer than the period (e.g., T1 in FIG. 2b) of the internal clock.

In an embodiment (e.g., FIG. 1), the clock circuit may further comprise a spread spectrum circuit (e.g., 110 in FIG. 1) and a summing circuit (e.g., 120 in FIG. 1). The summing circuit may be coupled among the spread spectrum circuit, the frequency hopping circuit and the frequency divider. The spread spectrum circuit may provide the second divisor number, and the summing circuit may calculate the sum of the first divisor number and the second divisor number.

In an embodiment (e.g., FIG. 1), the clock circuit may further comprise a sigma delta modulator (e.g., 130 in FIG. 1) coupled between the frequency divider and the frequency hopping circuit. The sigma delta modulator may perform a sigma delta modulation on the sum of the first divisor number and the second divisor number, and may accordingly generate a modulated divisor number (e.g., sdm1 in FIG. 1). When the frequency divider performs the frequency division according to the first divisor number, the frequency divider may perform the frequency division according to the modulated divisor number.

In an embodiment (e.g., FIG. 1), the frequency hopping circuit may comprise a first multiplexer (e.g., m1), a second multiplexer (e.g., m2) and an internal control circuit (e.g., 103). The first multiplexer may comprise two input terminals, an output terminal and a selection terminal respectively coupled to a first node (e.g., n1), a sixth node (e.g., n6), a second node (e.g., n2) and a fifth node (e.g., n5). The second multiplexer may comprise two input terminals, an output terminal and a selection terminal respectively coupled to the first node, the second node, a third node (e.g., n3) and a fourth node (e.g., n4). The internal control circuit may comprise two input terminals and two output terminals respectively coupled to the first node, a seventh node (e.g., n7), the fifth node and the sixth node. The first node may be further coupled to the input number, the fourth node may be further coupled to the hopping enabling signal (e.g., fh_en). The internal control circuit may check whether the convergence condition is satisfied, and may accordingly provide a hopping ready signal (e.g., fh_rdy) at the fifth node. If the convergence condition is not satisfied, the internal control circuit may further calculate an internal number (e.g., s1 in FIG. 1 and FIG. 4) outputted to the sixth node. The first multiplexer may selectively couple (conduct or electrically connect) one of the first node and the sixth node to the second node according to a logic value of the hopping ready signal. The second multiplexer may selectively couple (conduct or electrically connect) one of the first node and the second node to the third node according to a logic value of the hopping enabling signal. The frequency hopping circuit may provide the first divisor number at the seventh node according to a signal at the third node.

In an embodiment (e.g., FIG. 1), the frequency hopping circuit may further comprise a flipflop (e.g., 1062). The flipflop may comprise an input terminal, an output terminal and a clock terminal respectively coupled to the third node, the seventh node and the internal clock (e.g., sdm_ck).

In an embodiment (e.g., FIG. 1), the frequency hopping circuit may further comprise a front multiplexer (e.g., m0) and a front flipflop (e.g., 1061). The front multiplexer may comprise two input terminals, an output terminal and a selection terminal respectively coupled to a source number (e.g., fra0), the first node, a front node (e.g., n0) and a synchronized indication signal (e.g., chg_sync). The front flipflop may comprise an input terminal, an output terminal and a clock terminal respectively coupled to the front node, the first node and the internal clock (e.g., sdm_ck). The front multiplexer may selectively couple (conduct or electrically connect) one of the source number and the first node to the front node according to a logic value of the synchronized indication signal.

In an embodiment (e.g., FIG. 1), the clock circuit may further comprise a facilitation circuit (e.g., 150). The facilitation circuit may be coupled to the frequency divider, and may output a first clock (e.g., ck1) to the frequency divider. When the frequency divider performs the frequency division, the frequency divider may perform the frequency division on the first clock to generate a second clock (e.g., ck2).

In an embodiment (e.g., FIG. 1), the facilitation circuit may further control timing of the first clock according to timing (frequency and/or phase) of the second clock.

In an embodiment (e.g., FIG. 1), the clock circuit may further comprise a detector (e.g., 152), a filter (e.g., 154) and an oscillator (e.g., 156). The detector may comprise two input terminals and an output terminal respectively coupled to a reference clock (e.g., fref_ck), the second clock (e.g., ck2) and a first interior node (e.g., u1). The filter may comprise an input terminal and an output terminal respectively coupled to the first interior node and a second interior node (e.g., u2). The oscillator may comprise an input terminal and an output terminal respectively coupled to the second interior node and the frequency divider. The detector may detect timing difference between the reference clock and the second clock, and may accordingly provide a first interior signal (e.g., su1) at the first interior node. The filter may perform a signal process on the first interior signal, and may accordingly provide a second interior signal (e.g., su2) at the second interior node. The oscillator may generate the first clock according to the second interior signal, so timing of the first clock may relate to a signal value of the second interior signal.

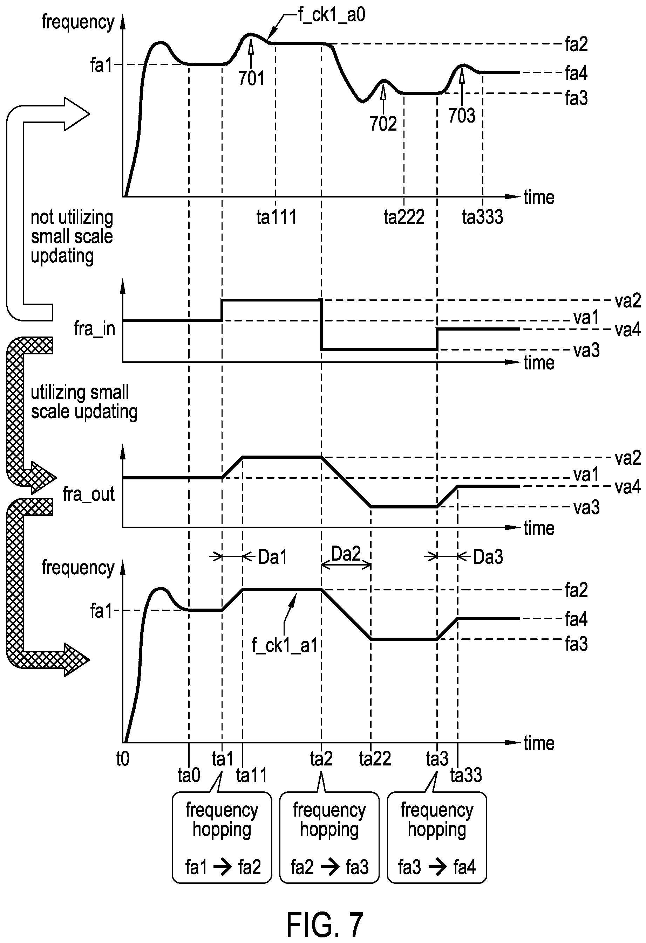

An object of the present disclosure is providing a clock circuit (e.g., 10 in FIG. 1) which may improve frequency hopping. The clock circuit may comprise a frequency divider (e.g., 140) and a frequency hopping circuit (e.g., 100). The frequency divider may perform a frequency division according to a first divisor number (e.g., fra_out). The frequency hopping circuit may be coupled to the frequency divider, and may provide the first divisor number. The clock circuit may provide a clock according to a result of the frequency division performed by the frequency divider. When the clock circuit is requested to cause a frequency of the clock to hop from a first frequency to a second frequency (e.g., from fa1 to fa2, or from fa2 to fa3 in FIG. 7), the clock circuit may stabilize the frequency of the clock to the second frequency after an interval (e.g., Da1 or Da2 in FIG. 7). During the interval, the frequency hopping circuit may stepwise change the first divisor number, such that, during the interval, the frequency of the clock may not fall after rising; e.g., the frequency of the clock may not suffer a frequency overshoot (e.g., 701 or 702 in FIG. 7) during the interval. When hopping from the first frequency to the second frequency (e.g., from fa1 to fa2, or from fa2 to fa3), if the second frequency (e.g., fa2) is greater (higher) than the first frequency (e.g., fa1), the frequency hopping circuit may, during the interval (e.g., Da1), cause the frequency of the clock not to rise above the second frequency and then fall to the second frequency. If the second frequency (e.g., fa3) is less (lower) than the first frequency (e.g., fa2), the frequency hopping circuit may, during the interval (e.g., Da2), cause the frequency of the clock not to rise above the second frequency and then fall down to the second frequency again after having fallen down to the second frequency.

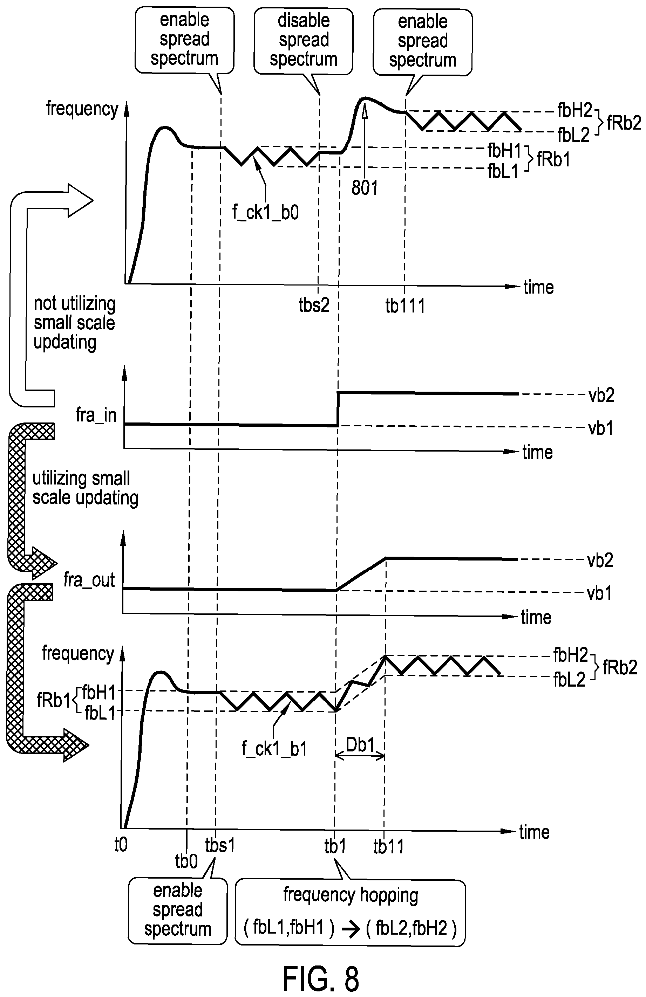

In an embodiment (e.g., FIG. 8), when the frequency divider performs the frequency division according to the first divisor number, the frequency divider may perform the frequency division according to a sum of the first divisor number and a second divisor number (e.g., ramp2 in FIG. 1). The clock circuit may further comprise a spread spectrum circuit (e.g., 110 in FIG. 1) which may provide the second divisor number (e.g., ramp2). When the spread spectrum circuit enables a spread spectrum function, the spread spectrum circuit may cause the second divisor number to vary between a lower bound value (e.g., vL0 in FIG. 2b) and an upper bound value (e.g., vH0 in FIG. 2b). When the spread spectrum circuit enables the spread spectrum function and the frequency hopping circuit causes the first divisor number to equal a first value (e.g., vb1 in FIG. 8), the frequency of the clock may spread over a first spread spectrum range (e.g., fRb1 in FIG. 8). When the clock circuit is requested to cause the frequency of the clock to hop from the first spread spectrum range to a second spread spectrum range (e.g., fRb2 in FIG. 8), the clock circuit may cause the frequency of the clock to steadily spread over the second spread spectrum range after a second interval (e.g., Db1 in FIG. 8). During the second interval, the frequency hopping circuit may stepwise change the first divisor number, and the spread spectrum circuit may keep on enabling the spread spectrum function.

An object of the present disclosure is providing a method (e.g., 400 in FIG. 4) applied to a clock circuit (e.g., 10 in FIG. 4). The clock circuit may comprise a frequency divider (e.g., 140 in FIG. 1), the frequency divider may perform a frequency division according to a first divisor number (e.g., fra_out in FIG. 1 and FIG.4), and the clock circuit may provide a clock according to a result of the frequency division performed by the frequency divider. The method may comprise: when causing the clock to hop to a frequency or a spread spectrum range corresponding to an input number (e.g., fra_in), proceeding to a decision step (e.g., 410 in FIG. 4) to determine if a convergence condition is satisfied; if the convergence condition is not satisfied, proceeding to a stepping step (e.g., 412 in FIG. 4); and if the convergence condition is satisfied, proceeding to a setting step (e.g., 414 in FIG. 4). The stepping step may comprise: updating the first divisor number from a previous value (e.g., fra_out[i-1] in FIG. 1) to a current value (e.g., fra_out[i] in FIG. 1) which does not equal the input number, and iterating the decision step. The setting step may comprise: causing the first divisor number to equal the input number.

In an embodiment (e.g., FIG. 1), the clock circuit may further comprise a facilitation circuit (e.g., 150 in FIG. 1), wherein the facilitation circuit and the frequency divider may form a phase lock loop (e.g., 170 in FIG. 1).

Numerous objects, features and advantages of the present disclosure will be readily apparent upon a reading of the following detailed description of embodiments of the present disclosure when taken in conjunction with the accompanying drawings. However, the drawings employed herein are for the purpose of descriptions and should not be regarded as limiting.

### BRIEF DESCRIPTION OF THE DRAWINGS

The above objects and advantages of the present disclosure will become more readily apparent to those ordinarily skilled in the art after reviewing the following detailed description and accompanying drawings, in which:
FIG. 1 illustrates a clock circuit according to an embodiment of the present disclosure, wherein the clock circuit may comprise a spread spectrum circuit and a frequency hopping circuit;
FIG. 2a and FIG. 2b illustrate waveform and timing embodiments of a related number respectively when the spread spectrum circuit in FIG. 1 does not enable a spread spectrum function and when the spread spectrum circuit in FIG. 1 enables the spread spectrum function;
FIG. 3a and FIG. 3b, by an example, illustrate waveform and timing embodiments of related signals and numbers when the frequency hopping circuit in FIG. 1 operates;
FIG. 4 illustrates a flowchart according to an embodiment of the present disclosure;
FIG. 5 and FIG. 7, by examples, illustrate waveform and timing embodiments of related signals and numbers when the clock circuit in FIG. 1 performs a normal frequency hopping; and
FIG. 6 and FIG. 8, by examples, illustrate waveform and timing embodiments of related signals and numbers when the clock circuit in FIG. 1 performs a spread spectrum frequency hopping.

### DETAILED DESCRIPTION

FIG. 1 depicts a clock circuit 10 according to an embodiment of the present disclosure; the clock circuit 10 may be a clock generator, a clock synthesizer, or a local oscillator for providing local carrier signal(s), etc. For example, in an embodiment, the clock circuit 10 may provide one or more clocks for a processor (not shown), so the processor may operate (e.g., may execute program codes and/or may perform digital signal processing) according to timing (frequency and/or phase) of the one or more clocks. In another embodiment, the clock circuit 10 may provide one or more clocks for a wireline interface circuit (e.g., a physical layer circuit compliant to a certain wireline communication protocol, not shown), so the interface circuit may receive and/or transmit digital signal(s) according to timing of the one or more clocks. In still another embodiment, the clock circuit 10 may provide one or more carrier signals for a wireless radiofrequency transceiver (not shown), so the radiofrequency transceiver may transmit and/or receive wireless radiofrequency signal(s) at one or more bands respectively corresponding to the one or more carrier signals.

As shown in FIG. 1, the clock circuit 10 may comprise a frequency hopping circuit 100, a spread spectrum circuit 110, a summing circuit 120, a sigma delta modulator 130, a frequency divider 140, a facilitation circuit 150 and a synchronization circuit 160.

In an embodiment of the present disclosure, the facilitation circuit 150 may comprise two input terminals and an output terminal respectively coupled to a clock fref_ck and two nodes u3 and u4; as shown in FIG. 1, according to an embodiment of the present disclosure, the facilitation circuit 150 may further comprise a detector 152, a filter 154 and an oscillator 156.

In the clock circuit 10, the frequency divider 140 may comprise two input terminals and an output terminal respectively coupled to the node u3, a node a8 and the node u4. The sigma delta modulator 130 may comprise an output terminal and an input terminal respectively coupled to the node n8 and another node a7.

In the clock circuit 10, the synchronization circuit 160 may comprise three input terminals and an output terminal respectively coupled to a signal chg_in, a clock sdm_ck, a signal fbk_rstb and a node a4; as shown in FIG. 1, according to an embodiment of the present disclosure, the synchronization circuit 160 may further comprise three flipflops 162, 164 and 166, and a logic gate g1.

In the clock circuit 10, the spread spectrum circuit 110 may comprise four input terminals and an output terminal respectively coupled to the clock sdm_ck, the signal fbk_rstb, another signal ssc_en, the node a4 and another node a5. The summing circuit 120 may comprise four input terminals and an output terminal respectively coupled to the clock sdm_ck, the signal fbk_rstb, a node n7, the node a5 and the node a7; as shown in FIG. 1, according to an embodiment of the present disclosure, the summing circuit 120 may further comprise an adder 122 and a flipflop 124.

In the clock circuit 10, the frequency hopping circuit 100 may comprise five input terminals and an output terminal respectively coupled to the clock sdm_ck, the signal fbk_rstb, a source number fra0, a signal fh_en, the node a4 and the node n7; as shown in FIG. 1, according to an embodiment of the present disclosure, the frequency hopping circuit 100 may further comprise three multiplexers m0, m1 and m2, two flipflops 1061 and 1062, and an internal control circuit 103.

In the clock circuit 10, the facilitation circuit 150 may output a clock ck1 at the node u3, the sigma delta modulator 130 may perform a sigma delta modulation on a divisor number ramp_out to generate another divisor number sdm1, the frequency divider 140 may perform a frequency division on the clock ck1 according to the divisor number sdm1 to generate a clock ck2, such that a frequency of the clock ck2 may substantially equal a frequency of the clock ck1 divided by the divisor number ramp_out. In an embodiment, the divisor number ramp_out may not be an integer, e.g., the divisor number ramp_out may comprise an integer portion and a fractional portion (i.e., a non-integer portion).

In the facilitation circuit 150 of the clock circuit 10, the detector 152 may comprise two input terminals and an output terminal respectively coupled to the clock fref_ck, the node u4 and a node u1, the filter 154 may comprise an input terminal and an output terminal respectively coupled to the node u1 and another node u2; the oscillator 156 may comprise an input terminal and an output terminal respectively coupled to the nodes u2 and u3. The detector 152 may detect timing (frequency and/or phase) difference between the clocks fref_ck and ck2, and may accordingly provide a signal su1 at the node u1; the filter 154 may perform a signal process of filtering on the signal su1, and may accordingly provide a signal su2 at the node u2; the oscillator 156 may generate the clock ck1 under control of the signal su2, so timing of the clock ck1 may relate to a signal value of the signal su2.

In the clock circuit 10, the facilitation circuit 150 and the frequency divider 140 may form a phase lock loop 170, and may control timing (frequency and/or phase) of the clock ck1 according to timing of the clocks fref_ck and ck2. The phase lock loop 170 may lock timing of the clocks ck1 and ck2 to be synchronized with timing of the clock fref_ck; i.e., when the phase lock loop 170 accomplishes phase lock, the phase lock loop 170 may maintain a predefined mutual relation among timing of the clocks ck1, ck2 and fref_ck, e.g., may cause a k-th and a (k+Nc2)-th rising edges (or falling edges) of the clock ck1 to respectively align a j-th and a (j+Nc1)-th rising edges (or falling edges) of the clock fref_ck, wherein the value Nc1 may be an integer greater than or equal to one, the value Nc2 may be an integer greater than or equal to one, and the values Nc1 and Nc2 may be the same or different. The phase lock loop 170 shown in FIG. 1 may just be one of various embodiments; in other embodiments not depicted, the phase lock loop 170 (and/or the facilitation circuit 150) may comprise other circuits, such as one or more additional frequency dividers, detectors and/or feedback circuits (not shown).

In an embodiment, cooperation of the facilitation circuit 150 and the frequency divider 140 may cause the frequency of the clock ck2 to relate to (e.g., to be substantially equal to) a frequency of the clock fref_ck, and may cause the frequency of the clock ck1 to relate to (e.g., to be substantially equal to) the frequency of the clock fref_ck times the divisor number ramp_out. In an embodiment, the clock fref_ck may be a reference clock, and the frequency of the clock fref_ck may be a constant.

In the clock circuit 10, the synchronization circuit 160 may, under triggering of the clock sdm_ck, provide a signal chg_sync at the node a4 according to the signal chg_in. Under control of the signal chg_sync (as well as the clock sdm_ck and the signal fbk_rstb), the frequency hopping circuit 100 may provide a divisor number fra_out at the node n7 according to the source number fra0. Under control of the signal ssc_en (as well as the signal chg_sync, the clock sdm_ck and the signal fbk_rstb), the spread spectrum circuit 110 may provide a divisor number ramp2 at the node a5. Under triggering of the clock sdm_ck, the summing circuit 120 may sum the two divisor numbers fra_out and ramp2, and may accordingly provide the divisor number ramp_out.

In the clock circuit 10, the frequency hopping circuit 100 may control a value of the divisor number fra_out to implement a frequency hopping function for the clock circuit 10. The spread spectrum circuit 110 may control a value of the divisor number ramp2 to implement a spread spectrum function for the clock circuit 10. In the clock circuit 10, whether the signal ssc_en is logic 1 may reflect whether to enable the spread spectrum function of the spread spectrum circuit 110, and whether the signal fh_en is logic 1 may reflect whether to enable a small scale updating (to be described later) of the present disclosure when the frequency hopping circuit 100 implements the frequency hopping function. When the spread spectrum circuit 110 enables the spread spectrum function, the frequency of the clock ck1 may spread over a spread spectrum range. When the signal ssc_en is logic 0, value switch of the signal chg_in and the source number fra0 may represent that the clock circuit 10 is requested to perform a normal frequency hopping, so the frequency of the clock ck1 may hop from a frequency to another frequency. When the signal ssc_en is logic 1, value switch of the signal chg_in and the source number fra0 may represent that the clock circuit 10 is requested to perform a spread spectrum frequency hopping, so the frequency of the clock ck1 may hop from a spread spectrum range to another spread spectrum range.

In the synchronization circuit 160, the flipflop 162 may comprise an input terminal (labeled by "D"), an output terminal (labeled by "Q"), a clock terminal and a reset terminal (labeled by "rst") respectively coupled to the signal chg_in, a node a1, the clock sdm_ck and the signal fbk_rstb; the flipflop 164 may comprise an input terminal, an output terminal, a clock terminal and a reset terminal respectively coupled to the node a1, a node a2, the clock sdm_ck and the signal fbk_rstb; the flipflop 166 may also comprise an input terminal, an output terminal, a clock terminal and a reset terminal respectively coupled to the node a2, another node a3, the clock sdm_ck and the signal fbk_rstb. The logic gate g1 may comprise two input terminals and an output terminal respectively coupled to the node a2, a3 and a4. In an embodiment, the flipflop 162 may sample the signal chg_in at each significant edge of the clock sdm_ck, and may output a result of the sampling to the node a1; the flipflop 164 may sample a signal at the node a1 at each significant edge of the clock sdm_ck, and may output a result of the sampling to the node a2; the flipflop 166 may sample a signal at the node a2 at each significant edge of the clock sdm_ck, and may output a result of the sampling to the node a3. Said significant edge of the clock sdm_ck may be a rising edge of the clock sdm_ck, or a falling edge of the clock sdm_ck. The logic gate g1 may perform a logic operation on the signals at the nodes a2 and a3, and may accordingly form the signal chg_sync at the node a4; in an embodiment, the logic gate g1 may be an exclusive OR. When a logic value of the signal chg_in does not switch (remains logic 0 or logic 1), the synchronization circuit 160 may cause the signal chg_sync to remain logic 0; in response to logic value switch (e.g., from logic 0 to logic 1 or from logic 1 to logic 0) of the signal chg_in, the synchronization circuit 160 may form a pulse of logic 1 in the signal chg_sync, wherein the pulse may start at a corresponding significant edge of the clock sdm_ck, and may last a period of the clock sdm_ck.

In the clock circuit 10, when the signal ssc_en is logic 0, the spread spectrum circuit 110 may cause the divisor number ramp2 to remain a certain constant value v0 (which may be zero or nonzero); FIG. 2a depicts a waveform and timing embodiment of the divisor number ramp2 when the signal ssc_en is logic 0. On the other hand, when the signal ssc_en is logic 1, the spread spectrum circuit 110 may cause the divisor number ramp2 to periodically vary between a lower bound value vL0 and an upper bound value vH0; FIG. 2b depicts a waveform and timing embodiment of the divisor number ramp2 when the signal ssc_en is logic 1, wherein a period Tss1 may represent a period during which the divisor number ramp2 varies. As shown in FIG. 2b, when the signal ssc_en is logic 1, the spread spectrum circuit 110 may, during one said period Tss1, cause the divisor number ramp2 to rise (e.g., to monotonously increase) from the lower bound value vL0 to the upper bound value vH0, and then to fall (e.g., to monotonously decrease) from the upper bound value vH0 to the lower bound value vL0. In an embodiment, when the spread spectrum circuit 110 causes the divisor number ramp2 to rise from the lower bound value vL0 to the upper bound value vH0, the spread spectrum circuit 110 may cause the divisor number ramp2 to increase by a value dr1 at each period T1 of the clock sdm_ck. For example, as shown in FIG. 2b, in response to a rising edge of the clock sdm_ck at a time point tr[q1], the spread spectrum circuit 110 may cause the divisor number ramp2 to be updated from a previous value ramp2[q1-1] to a current value ramp2[q1], wherein the value ramp2[q1] may equal the value ramp2[q1-1] plus the value dr1. After one period T1 of the clock sdm_ck, in response to a consecutive rising edge of the clock sdm_ck at another time point tr[q1+1] (tr[q1+1] = tr[q1] + T1), the spread spectrum circuit 110 may cause the divisor number ramp2 to be updated from the value ramp2[q1] to a value ramp2[q1+1], and the value ramp2[q1+1] may equal the value ramp2[q1] plus the value dr1.

On the other hand, when the spread spectrum circuit 110 causes the divisor number ramp2 to fall from the upper bound value vH0 to the lower bound value vL0, the spread spectrum circuit 110 may cause the divisor number ramp2 to decrease by a value dr2 at each period T1 of the clock sdm_ck. For example, as shown in FIG. 2b, in response to a rising edge of the clock sdm_ck at a time point tr[q2], the spread spectrum circuit 110 may cause the divisor number ramp2 to be updated from a previous value ramp2[q2-1] to a current value ramp2[q2], wherein the value ramp2[q2] may equal the value ramp2[q2-1] minus the value dr2. After one period T1 of the clock sdm_ck, in response to a consecutive rising edge of the clock sdm_ck at another time point tr[q2+1] (tr[q2+1] = tr[q2] + T1), the spread spectrum circuit 110 may cause the divisor number ramp2 to be updated from the value ramp2[q2] to a value ramp2[q2+1], and the value ramp2[q2+1] may equal the value ramp2[q2] minus the value dr2. In an embodiment, the values dr1 and dr2 may be positive values; in an embodiment, the values dr1 and dr2 may be equal. In an embodiment, the period Tss1 during which the divisor number ramp2 varies to rise and fall may be longer than the period T1 of the clock sdm_ck; e.g., the period Tss1 may cover a plurality of the period T1.

As shown in FIG. 1, in the summing circuit 120, the adder 122 may comprise two input terminals and an output terminal respectively coupled to the node a5, the node n7 and another node a6; the flipflop 124 may comprise an input terminal, an output terminal, a clock terminal and a reset terminal respectively coupled to the node a6, the node a7, the clock sdm_ck and the signal fbk_rstb. The adder 122 may calculate a sum of the divisor numbers fra_out and ramp2, and may output a result of the summing to the node a6; the flipflop 124 may sample a signal at the node a6 at each significant edge of the clock sdm_ck, and may accordingly form the divisor number ramp_out at the node a7.

As shown in FIG. 1, in the frequency hopping circuit 100, the multiplexer m0 may comprise a selection terminal, two input terminals and an output terminal respectively coupled to the node a4, the source number fra0 and another two nodes n1 and n0. The flipflop 1061 may comprise a clock terminal, a reset terminal, an input terminal and an output terminal respectively coupled to the clock sdm_ck, the signal fbk_rstb, the node n0 and the node n1. The multiplexer m1 may comprise two input terminals, an output terminal and a selection terminal respectively coupled to the node n1 and another three nodes n6, n2 and n5. The multiplexer m2 may comprise a selection terminal, two input terminals and an output terminal respectively coupled to the signal fh_en, the node n1, the node n2 and another node n3. The flipflop 1062 may comprise a clock terminal, a reset terminal, an input terminal and an output terminal respectively coupled to the clock sdm_ck, the signal fbk_rstb, the node n3 and the node n7. The internal control circuit 103 may comprise two input terminals and two output terminals respectively coupled to the nodes n1, n7, n5 and n6.

In the frequency hopping circuit 100, the multiplexer m0 may selectively couple (conduct or electrically connect) one of the source number fra0 and the node n1 to the node n0 according to a logic value at the node a4. In an embodiment, when the signal chg_sync at the node a4 is logic 1, the multiplexer m0 may couple the source number fra0 to the node n0; when the signal chg_sync is logic 0, the multiplexer m0 may couple the node n1 to the node n0. The flipflop 1061 may sample a signal at the node n0 at each significant edge of the clock sdm_ck, and may accordingly form an input number fra_in at the node n1. The flipflop 1062 may sample a signal at the node n3 at each significant edge of the clock sdm_ck, and may accordingly form the divisor number fra_out at the node n7. When the divisor number fra_out feeds back to the internal control circuit 103, the value of the divisor number fra_out may be referred to as a previous value fra_out[i-1]. In the frequency hopping circuit 100, the internal control circuit 103 may check whether a convergence condition is satisfied according to the input number fra_in and the divisor number fra_out respectively at the nodes n1 and n7, and may accordingly provide a signal fh_rdy at the node n5; if the convergence condition is not satisfied, the internal control circuit 103 may further calculate an internal number s1 to be outputted to the node n6. In an embodiment, the internal control circuit 103 may cause the signal fh_rdy to be logic 0 when the convergence condition is not satisfied, and may cause the signal fh_rdy to be logic 1 when the convergence condition is satisfied. Whether the convergence condition is satisfied may reflect whether the divisor number fra_out is close to the input number fra_in.

In the frequency hopping circuit 100, the multiplexer m1 may selectively couple (conduct or electrically connect) one of the nodes n1 and n6 to the node n2 according to a logic value at the node n5, and may accordingly provide an internal number s2 at the node n2. In an embodiment, when the signal fh_rdy at the node n5 is logic 1, the multiplexer m1 may couple the input number fra_in at the node n1 to the node n2; when the signal fh_rdy is logic 0, the multiplexer m1 may couple the internal number s1 at the node n6 to the node n2. The multiplexer m2 may selectively couple (conduct or electrically connect) one of the nodes n1 and n2 to the node n3. In an embodiment, when the signal fh_en is logic 1, the multiplexer m2 may couple the internal number s2 at the node n2 to the node n3; when the signal fh_en is logic 0, the multiplexer m2 may couple the input number fra_in at the node n1 to the node n3. When the flipflop 1062 samples the signal at the node n3, a signal value at the node n3 may be referred to as a current value fra_out[i] of the divisor number fra_out.

In an embodiment of the present disclosure, when the internal control circuit 103 calculates the internal number s1, the internal control circuit 103 may subtract the previous value fra_out[i-1] from a value of the input number fra_in to obtain a difference number df1. If the value of the input number fra_in is greater than the previous value fra_out[i-1] of the divisor number fra_out and the difference number df1 is therefore positive, the internal circuit 103 may cause the internal number s1 to equal the previous value fra_out[i-1] plus a step value rg_ms; on the other hand, If the value of the input number fra_in is less than the previous value fra_out[i-1] of the divisor number fra_out and the difference number df1 is therefore negative, the internal circuit 103 may cause the internal number s1 to equal the previous value fra_out[i-1] minus the step value rg_ms. In an embodiment, the step value rg_ms may be a predetermined positive value, e.g., a predefined positive constant.

In the clock circuit 10 shown in FIG. 1, the clocks ck1, ck2 and sdm_ck may be referred to as a first clock, a second clock and an internal clock, respectively. The signals su1 and su2 may be referred to as an error signal and an oscillation control signal, respectively. The divisor numbers sdm1, fra_out, ramp2 and ramp_out may be referred to as a modulated divisor number, a first divisor number, a second divisor number and a summed divisor number, respectively. The signal chg_in may be referred to as an indication signal, the signal chg_sync may be referred to as a synchronized indication signal, the signal fh_rdy may be referred to as a hopping ready signal, the signal fh_en may be referred to as a hopping enabling signal, and the signal ssc_en may be referred to as a spread spectrum enabling signal. A combination comprising the synchronization circuit 160, the spread spectrum circuit 110, the frequency hopping circuit 100 and the summing circuit 120 may be referred to as a divisor number module; under control and triggering of the signals fh_en, ssc_en, chg_in, fbk_rstb and the clock sdm_ck, the divisor number module may control a value of the divisor number ramp_out according to the source number fra0.

By an example, FIG. 3a depicts timing and waveform embodiments of related signals and numbers of the frequency hopping circuit 100 shown in FIG.1, wherein a signal sign_df1 may represent a sign of the difference number df1, and another signal stp1 may represent a product of the signal sign_df1 multiplied by the step value rg_ms. In the example shown in FIG. 3a, the signals fh_en and ssc_en (FIG. 1) may remain to be logic 1 and logic 0, respectively. In the frequency hopping circuit 100 shown in FIG. 1, in response to value switch of the signal chg_in and the source number fra0, the multiplexer m0 and the flipflop 1061 may, under triggering of the clock sdm_ck, cause the value of the input number fra_in to switch. In the example of FIG. 3a, value switch of the input number fra_in from a value v1 to a smaller value v2 at a time point t1 may represent that the clock circuit 10 is requested to perform the normal frequency hopping at the time point t1, so the frequency of the clock ck1 may hop from a frequency corresponding to the value v1 to a lower frequency corresponding to the value v2. In an embodiment, the time point t1 may be at a certain significant edge (e.g., a rising edge in the example of FIG. 3a) of the clock sdm_ck. As shown in FIG. 3a, before the time point t1, the values of the input number fra_in and the divisor number fra_out may both equal the value v1, the convergence condition is therefore satisfied, and the internal control circuit 103 may cause the signal fh_rdy to be logic 1.

At the time point t1, when the input number fra_in switches from the values v1 to v2, because the divisor number fra_out still remains the previous value v1, the convergence condition is then not satisfied, and the internal control circuit 103 may cause the signal fh_rdy to switch from logic 1 to logic 0. Since a value (v2-v1) is negative, the signal sign_df1 may switch to negative one (-1), the signal stp1 may switch to negative step value (-rg_ms), and the internal number s1 (FIG. 1) may switch to a value (v1-rg_ms) based on calculation of the internal control circuit 103. Because the signals fh_rdy and fh_en are respectively logic 0 and logic 1, the multiplexers m1 and m2 may couple the internal number s1 at the node n6 to the node n3, and the flipflop 1062 may update the divisor number fra_out from the previous value v1 to the current value (v1-rg_ms) at another time point (t1+T1) later than the time point t1 by one said period T1.

In response to that the divisor number fra_out is updated to the value (v1-rg_ms) at the time point (t1+T1), the internal control circuit 103 may cause the difference number df1 to switch to a value (v2-v1+rg_ms). Assuming that the difference number df1 is still negative and the convergence condition is still not satisfied, the internal control circuit 103 may cause the signal fh_rdy to remain logic 0, the signal sign_df1 may remain negative one, the signal stp1 may remain the negative step value (-rg_ms), and the internal number s1 may be updated to a value (v1-2*rg_ms). Because the signals fh_rdy and fh_en are respectively logic 0 and logic 1, the multiplexers m1 and m2 may couple the updated internal number s1 to the node n3, and the flipflop 1062 may update the divisor number fra_out from the previous value (v1-rg_ms) to the current value (v1-2*rg_ms) at another time point (t1+2*T1).

That is, as the signal fh_en remains logic 1, in response to that the input number fra_in switches from the value v1 to the lower value v2 at the time point t1, the frequency hopping circuit 100 may stepwise change (decrease) the value of the divisor number fra_out in small scale (by small scale step) at each period T1 of the clock sdm_ck, until the convergence condition is satisfied. After a plurality of the periods T1, in response to that the frequency hopping circuit 100 updates the divisor number fra_out to a value (v1-N1*rg_ms) at a time point (t11-T1) with the value N1 being an integer, if the convergence condition becomes satisfied, the internal control circuit 103 may cause the signal fh_rdy to switch from logic 0 to logic 1, the multiplexers m1 and m2 may couple the input number fra_in at the node n1 to the node n3, and the flipflop 1062 may cause the value of the divisor number fra_out to equal the value v2 of the input number fra_in at a later time point t11. In an embodiment, the time point t11 may be at a significant edge of the clock sdm_ck. In response to that the divisor number fra_out is updated to the value v2 at the time point t11, since both the input number fra_in and the divisor number fra_out equal the value v2, the signal sign_df1 may switch from negative one to zero, and the signal stp1 may switch from the negative step value (-rg_ms) to zero.

From FIG. 3a, it is understood that, as the signal fh_en remains logic 1, in response to that the input number fra_in switches from the values v1 to v2 at the time point t1, the frequency hopping circuit 100 may stepwise update the divisor number fra_out in small scale (may update the divisor number fra_out by small scale step), and may thereby postpone setting the divisor number fra_out to the value v2 until the time point t11. As shown in FIG. 3a, an interval D1 between the time points t1 and t11 may be referred to as a small scale updating interval, and a time length of the interval D1 may relate to (e.g., be positively correlated with, or approximate) a ratio (|v1-v2|/rg_ms). Operations of the frequency hopping circuit 100 during the interval D1 may be referred to as a small scale updating; by keeping the signal fh_en to remain logic 1, the frequency hopping circuit 100 may enable the small scale updating to stepwise change the value of the divisor number fra_out in response to value switch of the input number fra_in. The small scale updating of the frequency hopping circuit 100 of the present disclosure may effectively improve frequency hopping, and various technical advantages of the present disclosure will be explained later (e.g., by referring to FIG. 7 and FIG. 8).

As shown in FIG. 3a, at a time point t[i1] between the time points t1 and t11 when the convergence condition is not satisfied, the internal control circuit 103 in the frequency hopping circuit 100 may perform a stepping operation to update the divisor number fra_out from a previous value fra_out[i1-1] at a previous time point t[i1-1] to a current value fra_out[i1]. The time point t[i1] may be a time point later than the time point t[i1-1] by one said period T1 (i.e., t[i1] = t[i1-1]+T1), and the current value fra_out[i1] may be between the previous value fra_out[i1-1] and the value v2 of the input number fra_in, and may not equal the previous value fra_out[i1-1] and the value v2. For example, the current value fra_out[i1] may equal the previous value fra_out[i1-1] minus the step value rg_ms.

Similarly, at another time point t[i1+1] after the time point t[i1], the frequency hopping circuit 100 may update the divisor number fra_out from the previous value fra_out[i1] at the previous time point t[i1] to a current value fra_out[i1+1]. The time point t[i1+1] may be a time point later than the time point t[i1] by one said period T1 (i.e., t[i1+1] = t[i1]+T1), and the current value fra_out[i1+1] may be between the value v2 of the input number fra_in and the previous value fra_out[i1], and may not equal the previous value fra_out[i1] and the value v2. For example, the current value fra_out[i1+1] may equal the previous value fra_out[i1] minus the step value rg_ms.

In the example of FIG. 3a, the input number fra_in may switch from the value v2 to a higher (greater) value v3 at a time point t2 after the time point t11, and the value switch of the input number fra_in at the time point t2 may represent that the clock circuit 10 is requested to perform the normal frequency hopping at the time point t2, so the frequency of the clock ck1 may hop from the frequency corresponding to the value v2 to a higher frequency corresponding to the value v3. In an embodiment, the time point t2 may be at a significant edge of the clock sdm_ck. Following the example of FIG. 3a, FIG. 3b depicts waveform and timing embodiments of related signals and numbers after the time point t2; in the example of FIG. 3b, the signals fh_en and ssc_en may keep remaining logic 1 and logic 0, respectively. As shown in FIG. 3b, between the time points t11 and t2, the input number fra_in and the divisor number fra_out may both equal the value v2, so the difference number df1, the signal sign_df1 and the signal stp1 may be zero, the internal number s1 may equal the value v2, and the signal fh_rdy may be logic 1.

At the time point t2, when the input number fra_in switches from the values v2 to v3, because the divisor number fra_out still remains the previous value v2, the difference number df1 may switch to a value (v3-v2), the convergence condition may therefore become not satisfied, and the internal control circuit 103 may cause the signal fh_rdy to switch from logic 1 to logic 0. Since the value (v3-v2) is positive, the signal sign_df1 may switch to positive one (+1), the signal sign_df1 may switch to the step value rg_ms, and the internal number s1 may switch to a value (v2+rg_ms) based on calculation of the internal control circuit 103. Because the signals fh_rdy and fh_en are respectively logic 0 and logic 1, the multiplexers m1 and m2 may couple the internal number s1 at the node n6 to the node n3, and the flipflop 1062 may update the divisor number fra_out from the previous value v2 to the current value (v2+rg_ms) at a time point (t2+T1) later than the time point t2 by one said period T1.

In response to that the divisor number fra_out is updated to the value (v2+rg_ms) at the time point (t2+T1), the difference number df1 may switch to a value (v3-v2-rg_ms). Assuming the convergence condition is still not satisfied, the internal control circuit 103 may cause the signal fh_rdy to remain logic 0, the signal sign_df1 may remain positive one, the signal stp1 may remain the step value rg_ms, and the internal number s1 may be updated to a value (v2+2*rg_ms) by the internal control circuit 103. Because the signals fh_rdy and fh_en are respectively logic 0 and logic 1, the multiplexers m1 and m2 may couple the updated internal number s1 to the node n3, and the flipflop 1062 may update the divisor number fra_out from the previous value (v2+rg_ms) to the current value (v2+2*rg_ms) at another time point (t2+2*T1).

That is, as the signal fh_en remains logic 1, in response to that the input number fra_in switches from the value v2 to the higher value v3 at the time point t2, the frequency hopping circuit 100 may stepwise change (increase) the value of the divisor number fra_out in small scale at each period T1 of the clock sdm_ck, until the convergence condition is satisfied. After a plurality of the periods T1, in response to that the frequency hopping circuit 100 updates the divisor number fra_out to a value (v2+N2*rg_ms) at a time point (t22-T1) with the value N2 being an integer, if the convergence condition becomes satisfied, the internal control circuit 103 may cause the signal fh_rdy to switch from logic 0 to logic 1, the multiplexers m1 and m2 may couple the input number fra_in at the node n1 to the node n3, and the flipflop 1062 may cause the value of the divisor number fra_out to equal the value v3 of the input number fra_in at a later time point t22. In an embodiment, the time point t22 may be at a significant edge of the clock sdm_ck. In response to that the divisor number fra_out is updated to the value v3 at the time point t22, since both the input number fra_in and the divisor number fra_out equal the value v3, the signal sign_df1 may switch from positive one to zero, and the signal stp1 may switch from the step value rg_ms to zero.

From FIG. 3b, it is understood that, as the signal fh_en remains logic 1, in response to that the input number fra_in switches from the values v2 to v3 at the time point t2, the frequency hopping circuit 100 may stepwise update the divisor number fra_out in small scale, and may thereby postpone setting the divisor number fra_out to the value v3 until the time point t22. As shown in FIG. 3b, an interval D2 between the time points t2 and t22 may be referred to as another small scale updating interval, and a time length of the interval D2 may relate to (e.g., be positively correlated with, or approximate) a ratio (|v2-v3|/rg_ms). As shown in FIG. 3b, at a time point t[i2] between the time points t2 and t22 when the convergence condition is not satisfied, the frequency hopping circuit 100 may update the divisor number fra_out from a previous value fra_out[i2-1] at a previous time point t[i2-1] to a current value fra_out[i2]. The time point t[i2] may be a time point later than the time point t[i2-1] by one said period T1 (i.e., t[i2] = t[i2-1]+T1), and the current value fra_out[i2] may be between the previous value fra_out[i2-1] and the value v3 of the input number fra_in, and may not equal the previous value fra_out[i2-1] and the value v3. For example, the current value fra_out[i2] may equal the previous value fra_out[i2-1] plus the step value rg_ms.

Similarly, at another time point t[i2+1] after the time point t[i2], the frequency hopping circuit 100 may update the divisor number fra_out from the previous value fra_out[i2] at the previous time point t[i2] to a current value fra_out[i2+1]. The time point t[i2+1] may be a time point later than the time point t[i2] by one said period T1 (i.e., t[i2+1] = t[i2]+T1), and the current value fra_out[i2+1] may be between the previous value fra_out[i2] and the value v3 of the input number fra_in, and may not equal the previous value fra_out[i2] and the value v3. For example, the current value fra_out[i2+1] may equal the previous value fra_out[i2] plus the step value rg_ms.

In the example of FIG. 3b (and FIG. 3a), the input number fra_in may switch from the value v3 to a lower value v4 at a time point t3 after the time point t22, and may thereby represent that the clock circuit 10 is requested to perform the normal frequency hopping at the time point t3, so the frequency of the clock ck1 may hop from the frequency corresponding to the value v3 to a lower frequency corresponding to the value v4. As the signal fh_en remains logic 1, in response to that the input number fra_in switches from the values v3 to v4 at the time point t3, the frequency hopping circuit 100 may perform the small scale updating on the divisor number fra_out again to stepwise change the divisor number fra_out, and may thereby postpone setting the divisor number fra_out to the value v4 until a time point t33. An interval D3 between the time points t3 and t33 may be referred to as still another small scale updating interval. The stepwise changing of the divisor number fra_out performed by the frequency hopping circuit 100 between the time points t3 and t33 may be similar to the stepwise changing of the divisor number fra_out performed by the frequency hopping circuit 100 between the time points t1 and t11 (FIG. 3a), and is no longer described for conciseness.

FIG. 4 depicts a flowchart 400 according to an embodiment of the present disclosure; the flowchart 400 may be implemented by the frequency hopping circuit 100 in the clock circuit 10 shown in FIG. 1. Major steps of the flowchart 400 may be described as follows.

Step 402: the flowchart 400 may start. In an embodiment, the flowchart 400 may start after the phase lock loop 170 (FIG. 1) accomplishes a lock. For example, the flowchart 400 may start after the phase lock loop 170 stabilizes the mutual relation between timing of the clocks ck2 and fref_ck to steadily match a predefined lock condition.

Step 404: if a logic value of the signal fh_en equals a predefined logic value ca1 (e.g., logic 1), the flowchart 400 may proceed to step 406; if the signal fh_en does not equal the logic value ca1, the flowchart 400 may proceed to step 416.

Step 406: the internal control circuit 103 in the frequency hopping circuit 100 may calculate the difference number df1 (also shown in FIG. 1), i.e., a difference between the input number fra_in and the divisor number fra_out. Then the flowchart may proceed to step 408.

Step 408: the internal control circuit 103 in the frequency hopping circuit 100 may calculate the internal number s1 (also shown in FIG. 1). If the difference number df1 is positive, the internal control circuit 103 in the frequency hopping circuit 100 may cause the internal number s1 to equal the divisor number fra_out plus the step value rg_ms; if the difference number df1 is negative, the internal control circuit 103 in the frequency hopping circuit 100 may cause the internal number s1 to equal the divisor number fra_out minus the step value rg_ms; then the flowchart 400 may proceed to step 410. In an embodiment, if the difference number df1 equals zero, the frequency hopping circuit 100 may cause the internal number s1 to equal the divisor number fra_out.

Step 410: the internal control circuit 103 in the frequency hopping circuit 100 may check whether the convergence condition is satisfied. If the convergence condition is not satisfied, the flowchart 400 may proceed to step 412; if the convergence condition is satisfied, the flowchart 400 may proceed to step 414.

Step 412: the multiplexers m1, m2 and the flipflop 1062 in the frequency hopping circuit 100 may cause the divisor number fra_out to equal the internal number s1, and the flowchart 400 may iterate step 406.

Step 414: the multiplexers m1, m2 and the flipflop 1062 in the frequency hopping circuit 100 may cause the divisor number fra_out to equal the input number fra_in, and the flowchart 400 may proceed to step 418. In the flowchart 400, steps 406 and 408 may be respectively referred to as a difference number calculation step and a current value calculation step, steps 410, 412 and 414 may be respectively referred to as a decision step, a stepping step and a setting step; and, steps 406, 408, 410, 412 and 414 may form a small scale updating procedure 430.

Step 416: the multiplexer m2 and the flipflop 1062 in the frequency hopping circuit may cause the divisor number fra_out to equal the input number fra_in, and the flowchart 400 may proceed to step 418.

Step 418: if there is a need to repeat step 404 and/or the small scale updating procedure 430, the flowchart 400 may iterate step 404, otherwise the flowchart 400 may proceed to step 420. In an embodiment, the flowchart 400 may iterate step 404 when the input number fra_in updates and the logic value of the signal chg_in (FIG. 1) toggles. In an embodiment, the logic value switch of the signal chg_in may relate to value switch of the source number fra0. In response to the logic value switch of the signal chg_in, the synchronization circuit 160 may form a pulse of logic 1 in the signal chg_sync, the multiplexer m0 and the flipflop 1061 in the frequency hopping circuit 100 may update value of the input number fra_in to the value-switched source number fra0, e.g., at the time points t1 or t2 in FIG. 3a and FIG. 3b. When the flowchart 400 iterates step 404 and the small scale updating procedure 430 from step 418, the frequency hopping circuit 100 may repeatedly iterate from step 412 to steps 406 and 408 for a plurality of times respectively at a plurality of the periods T1 of the clock sdm_ck, and may thereby stepwise change the divisor number fra_out, e.g., during the interval D1 or D2 in FIG. 3a or FIG. 3b; eventually, as the flowchart 400 proceeds from step 410 to step 414, the frequency hopping circuit 100 may cause the divisor number fra_out to equal the input number fra_in, e.g., at the time point t11 or t12 in FIG. 3a or FIG. 3b.

In an embodiment of the present disclosure, whether the convergence condition is satisfied at step 410 may relate to a number of times that a historical trend of the sign of the difference number df1 shows a limit cycle during past iterations of step 406. For example, whether the convergence condition is satisfied may be: whether the number of times that the historical trend of the sign of the difference number df1 shows a limit cycle during iterations of step 406 is greater than a predefined convergence count. For example, when executing step 410, if the sign of the difference number df1 demonstrates an alternating pattern of "positive-negative-positive-negative" to show a limit cycle during most recent M (an integer) iterations of step 406, and the count M is greater than the predefined convergence count, then the internal control circuit 103 may determine that the convergence condition is satisfied.

In another embodiment of the present disclosure, whether the convergence condition is satisfied at step 410 may relate to (or may be) whether an absolute difference |df1| (i.e., absolute value of the difference number df1 calculated at step 406) between the input number fra_in and the divisor number fra_out is less than a threshold value ms1 (not depicted). The threshold value ms1 may be greater than, equal to or less than the step value rg_ms at step 408. In an embodiment, each of the divisor number fra_out and the threshold value ms1 may be a non-integer value, the frequency hopping circuit 100 may represent the divisor number fra_out and the threshold value ms1 by two binary values of a same number of bits (e.g., 28 bits), and the binary value representing the threshold value ms1 may have a least significant bit equal to one, and remaining bits equal to zero.

Continuing the example of FIG. 3a and FIG. 3b, FIG. 5 depicts waveform and timing embodiment of related signals and numbers when the clock circuit 10 in FIG. 1 performs the normal frequency hopping; in the example of FIG. 5, the signals fh_en and ssc_en (FIG. 1) may respectively remain logic 1 and logic 0. As shown in FIG. 5, since the signal ssc_en remains logic 0, the spread spectrum circuit 110 may cause the divisor number ramp2 to remain the value v0. Furthermore, in response to that the input number fra_in switches from the value v1 to the smaller value v2 at the time point t1, the small scale updating of the frequency hopping circuit 100 in the clock circuit 10 may stepwise change the divisor number fra_out from the value v1 to the value v2 during the interval D1 between the time points t1 and t11. Because the divisor number ramp_out provided by the summing circuit 120 is the sum of the divisor numbers fra_out and ramp2 respectively provided by the frequency hopping circuit 100 and the spread spectrum circuit 110, the divisor number ramp_out may also stepwise change from a value sv1 to a lower value sv2 during the interval D1, wherein the values sv1 and sv2 may respectively equal values (v1+v0) and (v2+v0). Since the divisor number sdm1 by which the frequency divider 140 performs the frequency division results from the divisor number ramp_out, a frequency f_ck1 of the clock ck1 may smoothly and gradually change from a frequency f1 to a lower frequency f2 during the interval D1 between the time points t1 and t11, and may steadily remain the frequency f2 after the time point t11. The frequencies f1 and f2 may respectively correspond to the values sv1 and sv2, e.g., may respectively equal frequencies (f_ref*sv1) and (f_ref*sv2), with the frequency f_ref (not depicted) being the frequency of the clock fref_ck.

Likewise, in response to that the input number fra_in switches from the value v2 to the higher value v3 at the time point t2, the small scale updating of the frequency hopping circuit 100 may stepwise change the divisor number fra_out from the value v2 to the value v3 during the interval D2 between the time points t2 and t22. Consequently, the divisor number ramp_out may stepwise change from the value sv2 to a higher value sv3 during the interval D2 between the time points t2 and t22, and the frequency f_ck1 of the clock ck1 may smoothly and gradually change from the frequency f2 to a higher frequency f3 during the interval D2 between the time points t2 and t22, and may steadily settle to the frequency f3 after the time point t22. The value sv3 may equal a value (v3+v0), and the frequency f3 may correspond to the value sv3, e.g., may equal a frequency (f_ref*sv3).

Similarly, in response to that the input number fra_in switches from the value v3 to the lower value v4 at the time point t3, the small scale updating of the frequency hopping circuit 100 may stepwise change the divisor number fra_out from the value v3 to the value v4 during the interval D3 between the time points t3 and t33. Consequently, the divisor number ramp_out may stepwise change from the value sv3 to a lower value sv4 during the interval D3 between the time points t3 and t33, and the frequency f_ck1 of the clock ck1 may smoothly and gradually change from the frequency f3 to a lower frequency f4 during the interval D3 between the time points t3 and t33, and may steadily settle to the frequency f4 after the time point t33. The value sv4 may equal a value (v4+v0), and the frequency f4 may correspond to the value sv4, e.g., may equal a frequency (f_ref*sv4).

By an example, FIG. 6 depicts waveform and timing embodiments of related signals and numbers when the clock circuit 10 performs the spread spectrum frequency hopping; in the example of FIG. 6, the signals fh_en and ssc_en (FIG. 1) may both remain to be logic 1. As shown in FIG. 6, since the signal ssc_en remains logic 1, the spread spectrum circuit 110 in the clock circuit 10 may cause the divisor number ramp2 to periodically vary between the lower bound value vL0 and the upper bound value vH0. When the input number fra_in switches from a value v6 to another value v7 at a time point t6, the value switch of the input number fra_in may represent that the clock circuit 10 is requested to cause the frequency of the clock ck1 to hop from a spread spectrum range corresponding to the value v6 to another spread spectrum range corresponding to the value v7.

Similar to FIG. 3a, as FIG. 6 shows, in response to that the input number fra_in switches from the value v6 to the lower value v7 at the time point t6, the frequency hopping circuit 100 in the clock circuit 10 may enable the small scale updating since the signal fh_en is logic 1; the divisor number fra_out may therefore stepwise change, and may postpone being equal to the value v7 until another time point t66. An interval D6 between the time points t6 and t66 may be referred to as a small scale updating interval, and a time length of the interval D6 may relate to a ratio |v6-v7|/rg_ms. Because the divisor number ramp_out provided by the summing circuit 120 is the sum of the divisor numbers fra_out and ramp2 respectively provided by the frequency hopping circuit 100 and the spread spectrum circuit 110, the divisor number ramp_out may stepwise change from a value range vR1 corresponding to the value v6 to a lower value range vR2 corresponding to the value v7 during the interval D6 between the timepoints t6 and t66, wherein the value range vR1 may be from a value svL1 to another value svH1, the value range vR2 may be from a value svL2 to another value svH2, and the values svL1, svH1, svL2 and svH2 may respectively equal values (v6+vL0), (v6+vH0), (v7+vL0) and (v7+vH0). Since the division number sdm1 by which the frequency divider 140 preforms the frequency division results from the divisor ramp_out, the frequency f_ck1 of the clock ck1 may smoothly and gradually change from a spread spectrum range fR1 to a lower spread spectrum range fR2 during the interval D6 between the time points t6 and t66, and may settle to the spread spectrum range fR2 after the time point t66. As shown in FIG. 6, the spread spectrum range fR1 may extend from a lower bound frequency fL1 to an upper bound frequency fH1, the spread spectrum range fR2 may extend from a lower bound frequency fL2 to an upper bound frequency fH2, and the spread spectrum ranges fR1 and fR2 may respectively correspond to the value ranges vR1 and vR2, e.g., the frequencies fL1, fH1, fL2 and fH2 may respectively equal frequencies (f_ref*svL1), (f_ref*svH1), (f_ref*svL2) and (f_ref*svH2).

By an example, FIG. 7 depicts improvement provided by the small scale updating of the frequency hopping circuit 100 of the present disclosure when the clock circuit 10 performs the normal frequency hopping; in the example of FIG. 7, the signal ssc_en (FIG. 1) may remain logic 0. In FIG. 7, a curve f_ck1_a1 may represent the frequency of the clock ck1 when the small scale updating of the present disclosure is utilized during the normal frequency hopping, and the curve f_ck1_a0 may represent the frequency of the clock ck1 when the small scale updating of the present disclosure is not utilized during the normal frequency hopping. When the signal ssc_en remains logic 0, if the signal fh_en (FIG. 1) remains logic 1, the frequency hopping circuit 100 may enable the small scale updating (i.e., the flowchart 400 in FIG. 4 may proceed from step 404 to the small scale updating procedure 430) to be utilized by the clock circuit 10; if the signal fh_en remains logic 0, the frequency hopping circuit 100 may not enable the small scale updating, and the clock circuit 10 may not utilize the small scale updating (i.e., the flowchart 400 in FIG. 4 may proceed from step 404 to step 416). When the signal fh_en is logic 0 and the frequency hopping circuit 100 dose not enable the small scale updating, the multiplexer m2 and the flipflop 1062 in the frequency hopping circuit (FIG. 1) may cause the divisor number fra_out to closely track the input number fra_in; if the input number switches from a first value to another second value, the divisor number fra_out will also rapidly switch from the first value to the second value, and will not gradually change to postpone reaching the second value until an interval elapses.

In the example of FIG. 7, when the input number fra_in equals a value va1, the phase lock loop 170 (FIG. 1) may accomplish lock between two time points t0 and ta0 to enter a lock status, and may then steadily maintain the frequency of the clock ck1 to remain a frequency fa1. At a later time point ta1, the input number fra_in may switch from the value va1 to a higher value va2 to request the clock circuit 10 to hop from the frequency fa1 corresponding to the value va1 to a higher frequency fa2 corresponding to the va2.

As the curve f_ck1_a1 shows, if the small scale updating of the present disclosure is utilized, the frequency hopping circuit 100 may change the divisor number fra_out gradually by small scale step after the time point ta1, so the divisor number fra_out may postpone reaching the value va2 until a time point ta11; as a result, the frequency of the clock ck1 may smoothly and gradually change from the frequency fa1 to the frequency fa2 at the time point ta11, and may steadily remain the frequency fa2 after the time point ta11. As the curve f_ck1_a1 shows, during an interval Da1 from the time points ta1 to ta11, because the divisor number fra_out stepwise changes in small scale, the divisor number ramp_out (FIG. 1) may also stepwise change in small scale, hence the phase lock loop 170 may stay in the lock status, and may not need to relock timing of the clock ck1. As previously described (e.g., by referring to FIG. 3a and FIG. 3b), when the signal fh_en remains logic 1 and therefore the frequency hopping circuit 100 enables the small scale updating, the frequency hopping circuit 100 may decrease or increase the divisor number fra_out by the step value rg_ms at each said period T1 during the small scale updating interval (e.g., Da1). In an embodiment, a quantity of the step value rg_ms may relate to a time length of the period T1 and/or characteristic(s) of the phase lock loop 170 (e.g., response time and stability), so the phase lock loop 170 will not exit the lock status during the small scale updating interval.

On the other hand, as the curve f_ck1_a0 shows, if the small scale updating is not utilized, the value switch of the input number fra_in at the time point ta1 will cause the values of the divisor numbers fra_out and ramp_out to rapidly switch, so the phase lock loop 170 will exit the lock status, and will need to relock timing of the clock ck1. During the relock, the frequency of the clock ck1 will rise from the frequency fa1 to exceed the frequency fa2, go downward for correction, and then be relocked to the frequency fa2 at a time point ta111. As shown in FIG. 7, the relock between the time points ta1 and ta111 will cause a frequency overshoot 701 in the curve f_ck1_a0. Comparing to the smooth change of the curve f_ck1_a1 during the interval Da1, the frequency overshoot 701 of the curve f_ck1_a0 represents that the phase lock loop 170 in the clock circuit 10 needs to consume additional power (energy) for the relock when hopping from the frequencies fa1 to fa2.

At another time point ta2, the input number fra_in may switch from the value va2 to a lower value va3 to request the clock circuit 10 to hop from the frequency fa2 to a lower frequency fa3 corresponding to the value va3. As the curve f_ck1_a1 shows, if the small scale updating of the present disclosure is utilized, the divisor number fra_out may stepwise change in small scale, and may postpone reaching the value va3 until a time point ta22; as a result, the frequency of the clock ck1 may smoothly and gradually change from the frequency fa2 to the frequency fa3 at the time point ta22, and may then steadily remain the frequency fa3. As the curve f_ck1_a1 shows, during an interval Da2 between the time points ta2 and ta22, because the divisor number fra_out stepwise changes in small scale, the divisor number ramp_out (FIG. 1) may also stepwise change in small scale, hence the phase lock loop 170 may not exit the lock status, and may not need to relock timing of the clock ck1. During the interval Da2, the frequency of the clock ck1 may substantially remain between the frequencies fa2 and fa3, and may substantially be not lower than the frequency fa3 and not higher than the frequency fa2.

On the other hand, as the curve f_ck1_a0 shows, if the small scale updating is not utilized, the value switch of the input number fra_in at the time point ta2 will cause the values of the divisor numbers fra_out and ramp_out to rapidly switch, so the phase lock loop 170 will need to relock timing of the clock ck1; during the relock, the frequency of the clock ck1 will fall from the frequency fa2 first, rise to exceed the frequency fa3, go downward for correction, and then be relocked to the frequency fa3 at a time point ta222. As shown in FIG. 7, the relock between the time points ta2 and ta222 will cause a frequency overshoot 702 in the curve f_ck1_a0. Comparing to the smooth change of the curve f_ck1_a1 during the interval Da2, the frequency overshoot 702 of the curve f_ck1_a0 represents that the phase lock loop 170 in the clock circuit 10 needs to consume additional power for the relock when hopping from the frequencies fa2 to fa3.

At another time point ta3, the input number fra_in may switch from the value va3 to a higher value va4 to request the clock circuit 10 to hop from the frequency fa3 to a higher frequency fa4 corresponding to the value va4. As the curve f_ck1_a1 shows, if the small scale updating of the present disclosure is utilized, the divisor number fra_out may stepwise change in small scale, and may postpone reaching the value va4 until a time point ta33; as a result, the frequency of the clock ck1 may smoothly and gradually change from the frequency fa3 to the frequency fa4 at the time point ta33, and may then steadily remain the frequency fa4. As the curve f_ck1_a1 shows, during an interval Da3 between the time points ta3 and ta33, because the divisor number fra_out stepwise changes in small scale, the divisor number ramp_out (FIG. 1) may also stepwise change in small scale, hence the phase lock loop 170 may not need to relock timing of the clock ck1. During the interval Da3, the frequency of the clock ck1 may substantially remain between the frequencies fa3 and fa4, and may substantially be not lower than the frequency fa3 and not higher than the frequency fa4.

On the other hand, as the curve f_ck1_a0 shows, if the small scale updating is not utilized, the value switch of the input number fra_in at the time point ta3 will cause the values of the divisor numbers fra_out and ramp_out to rapidly switch, so the phase lock loop 170 will need to relock timing of the clock ck1; during the relock, the frequency of the clock ck1 will rise from the frequency fa3 to exceed the frequency fa4, go downward for correction, and then be relocked to the frequency fa4 at a time point ta333. As shown in FIG. 7, the relock between the time points ta3 and ta333 will cause a frequency overshoot 703 in the curve f_ck1_a0. Comparing to the smooth change of the curve f_ck1_a1 during the interval Da3, the frequency overshoot 703 of the curve f_ck1_a0 represents that the phase lock loop 170 in the clock circuit 10 needs to consume additional power for the relock when hopping from the frequencies fa3 to fa4.

By an example, FIG. 8 depicts improvement provided by the small scale updating of the frequency hopping circuit 100 of the present disclosure when the clock circuit 10 performs the spread spectrum frequency hopping. In FIG. 8, a curve f_ck1_b1 may represent the frequency of the clock ck1 when the small scale updating of the present disclosure is utilized during the spread spectrum frequency hopping, and the curve f_ck1_b0 may represent the frequency of the clock ck1 when the small scale updating of the present disclosure is not utilized during the spread spectrum frequency hopping. When the signal fh_en (FIG. 1) remains logic 1, the frequency hopping circuit 100 may enable the small scale updating to be utilized by the clock circuit 10; when the signal fh_en remains logic 0, the frequency hopping circuit 100 may not enable the small scale updating, and the clock circuit 10 may not utilize the small scale updating.

In the example of FIG. 8, when the signal ssc_en is logic 0 and the input number fra_in equals a value vb1, the phase lock loop 170 in the clock circuit 10 may accomplish lock between two time points t0 and tb0 to enter a lock status, and may steadily maintain the frequency of the clock ck1 to remain a frequency fbH1. At a later time point tbs1, the signal ssc_en may switch form logic 0 to logic 1, so the spread spectrum circuit 110 may enable (start) the spread spectrum function; the spread spectrum circuit 110 may therefore cause the divisor number ramp2 to periodically vary, so the frequency of the clock ck1 may spread over a spread spectrum range fRb1 corresponding to the value vb1. The spread spectrum range fRb1 may be from a frequency fbL1 to the frequency fbH1. At another later time point tb1, the input number fra_in may switch from the value vb1 to another value vb2 to request the clock circuit 10 to hop from the spread spectrum range fRb1 to another spread spectrum range fRb2 corresponding to the value vb2. The spread spectrum range fRb2 may be between two frequencies fbL2 and fbH2.

As the curve f_ck_b1 shows, if the small scale updating of the present disclosure is utilized, the divisor number fra_out may stepwise change in small scale, and may postpone reaching the value vb2 until a time point tb11; as a result, the frequency of the clock ck1 may smoothly and gradually change from the spread spectrum range fRb1 to the spread spectrum range fRb2 at the time point tb11, and may steadily spread over the spread spectrum range fRb2 after the time point tb11. During an interval Db1 from time points tb1 to tb11, because the divisor number fra_out stepwise changes in small scale, the divisor number ramp_out (FIG. 1) may also stepwise change in small scale, hence the phase lock loop 170 may not exit the lock status, and may not need to relock timing of the clock ck1. During the interval Db1, the frequency of the clock ck1 may substantially remain between the highest one (the frequency fbH2 in the example of FIG. 8) and the lowest one (the frequency fbL1 in the example of FIG. 8) of the four frequencies fbL1, fbL2, fbH1 and fbH2.

On the other hand, as the curve f_ck1_b0 shows, if the small scale updating is not utilized during the spread spectrum frequency hopping, the signal ssc_en needs to switch from logic 1 to logic 0 at a time point tbs2 between the time points tbs1 and tb1 to disable the spread spectrum function of the spread spectrum circuit 110, so the spread spectrum function will not interfere relock during the frequency hopping. Then, when the input number fra_in switches from the values vb1 to vb2 at the time point tb1 to request the clock circuit 10 to perform the spread spectrum frequency hopping, the phase lock loop 170 will relock timing of the clock ck1. During the relock, the frequency of the clock ck1 will first rise to exceed the upper bound frequency fbH2 of the spread spectrum range fRb2 then fall for correction, and will be locked to the frequency fbH2 at a time point tb111. After the time point tb111, the signal ssc_en switches back from logic 0 to logic 1 to enable (start) the spread spectrum function of the spread spectrum circuit 110 again, so the frequency of the clock ck1 can spread over the spread spectrum range fRb2. As shown in FIG. 8, if the small scale updating is not utilized, the relock will cause a frequency overshoot 801 in the curve f_ck1_b0 between the time points tb1 and tb111. Compared to the smooth change of the curve f_ck1_b1 during the interval Db1, the frequency overshoot 801 of the curve f_ck1_b0 means that the phase lock loop 170 in the clock circuit 10 must consume extra power to hop from the spread spectrum ranges fRb1 to fRb2.

From FIG. 8, it is understood that if the small scale updating of the present disclosure is not utilized when performing the spread spectrum frequency hopping, not only the relock will cause the frequency overshoot, but also an additional control procedure of high complexity has to be implemented to disable and enable the spread spectrum function respectively before and after the relock. On the contrary, if the small scale updating of the present disclosure is utilized, the relock may no longer be necessary, and the spread spectrum function may not have to be disabled and enabled repeatedly; even if the spread spectrum circuit 110 keeps on enabling the spread spectrum function without disabling it, the small scale updating of the frequency hopping circuit 100 may successfully cause the frequency of the clock ck1 to hop from the spread spectrum ranges fRb1 to fRb2. That is, if the small scale updating of the present disclosure is utilized, the signal ssc_en may remain logic 1 after the time point tbs1, so the spread spectrum circuit 110 may keep on enabling the spread spectrum function before, during and after the interval Db1.

When the signal fh_en remains logic 1 and thereby causes the frequency hopping circuit 100 to enable the small scale updating, the frequency hopping circuit 100 may increase or decrease the divisor number fra_out by the step value rg_ms at each said period T1 during the small scale updating interval (e.g., Db1). When the signal ssc_en remains logic 1 and thereby causes the spread spectrum circuit 110 to enable the spread spectrum function, the spread spectrum circuit 110 may increase or decrease the divisor number ramp2 by the value dr1 or dr2 (FIG. 2b) at each said period T1. In an embodiment, the quantity of the step value rg_ms may relate to the time length of the period T1, quantities of the value dr1 and dr2, and/or the characteristic(s) of the phase lock loop 170 (e.g., response time and stability, etc.), so the phase lock loop 170 will not exit the lock status during the small scale updating interval.

In an embodiment (not depicted) of the clock circuit 10 in FIG. 1, the facilitation circuit 150 and the frequency divider 140 may not have to form a phase lock loop; as the frequency divider 140 performs the frequency division on the clock ck1 to generate the clock ck2, the clock ck2 may not be fed back to the facilitation circuit 150, and the facilitation circuit 150 may not control timing of the clock ck1 according to timing of the clock ck2. For example, the facilitation circuit 150 may be a clock generator for generating the clock ck1, and the generated clock ck1 may have a given frequency; in cooperation with the frequency division performed by the frequency divider 140, the frequency of the clock ck2 may equal the given frequency divided by the divisor number ramp_out. In such embodiment, when the spread spectrum circuit 110 enables the spread spectrum function, the spread spectrum circuit 110 may cause the frequency of the clock ck2 to spread over a spread spectrum range. When the signal ssc_en is logic 0, value switch of the signal chg_in and the source number fra0 may represent that the clock circuit 10 is requested to perform a normal frequency hopping, so the frequency of the clock ck2 may hop from a first frequency to another second frequency; if the signal fh_en remains logic 1, the frequency hopping circuit 100 may enable the small scale updating during the frequency hopping, and may thereby cause the frequency of the clock ck2 to smoothly and gradually change from the first frequency to the second frequency during a small scale updating interval, similar to the curve f_ck1_a1 in FIG. 7. When the ssc_en is logic 1, value switch of the signal chg_in and the source number fra0 may represent that the clock circuit 10 is requested to perform a spread spectrum frequency hopping, so the frequency of the clock ck2 may hop from a first spread spectrum range to another second spread spectrum range; if the signal fh_en remains logic 1, the frequency hopping circuit 100 may enable the small scale updating during the frequency hopping, and may thereby cause the frequency of the clock ck2 to smoothly and gradually change from the first spread spectrum range to the second spread spectrum range during a small scale updating interval, similar to the curve f_ck1_b1 in FIG. 8.

To sum up, the present disclosure may provide a small scale updating mechanism for a clock circuit (e.g., 10 in FIG. 1). When an input number (e.g., fra_in) switches from a first input value (e.g., va1 or vb1 in FIG. 7 or FIG. 8) to a second input value (e.g., va2 or vb2 in FIG. 7 or FIG. 8) to request the clock circuit to cause a frequency of a clock (e.g., ck1) to hop from a first frequency (e.g., fa1 in FIG. 7) to a second frequency (e.g., fa2 in FIG. 7) or from a first spread spectrum range (e.g., fRb1 in FIG. 8) to a second spread spectrum range (e.g., fRb2 in FIG. 8), the small scale updating of the present disclosure may cause a divisor number (e.g., fra_out in FIG. 1) related to the clock to stepwise change from the first input value to the second input value during an interval (e.g., Da1, Da2 or Da3 in FIG. 7, or Db1 in FIG. 8). During the interval, by utilizing the small scale updating of the present disclosure, the clock circuit may not have to consume additional power and resources to relock timing of the clock. Because the present disclosure may not need relock during frequency hopping, the present disclosure may perform frequency hopping when the spread spectrum function remains enabled, and may therefore prevent complex control for disabling and enabling the spread spectrum function respectively before and after the relock.

While the present disclosure has been described with reference to several embodiments, it is to be understood that the present disclosure needs not be limited to the disclosed embodiment. On the contrary, it is intended to cover various modifications and similar arrangements included within the spirit and scope of the appended claims which are to be accorded with the broadest interpretation so as to encompass all such modifications and similar structures.

## Claims

1. A clock circuit (10) improving frequency hopping, comprising:
a frequency divider (140), configured for performing a frequency division according to a first divisor number (fra_out); and
a frequency hopping circuit (100) coupled to the frequency divider, wherein:
when the clock circuit is requested to cause a frequency of a clock to hop from a first frequency (fa1) or a first spread spectrum (fRb1) to a second frequency (fa2) or a second spread spectrum range (fRb2) corresponding to an input number (fra_in), if a convergence condition (410) is not satisfied, the frequency hopping circuit is configured to perform a stepping operation (412) to update the first divisor number from a previous value (fra_out[i-1]) to a current value (fra_out[i]) which does not equal the input number.

2. The clock circuit of claim 1, wherein:
if the convergence condition is satisfied, the frequency hopping circuit is configured to cause the first divisor number to equal the input number.

3. The clock circuit of claim 1 or 2, wherein:
the frequency hopping circuit is further configured to perform a calculation operation (406) and a decision operation (410) before performing the stepping operation, and to iterate the calculation operation and the decision operation after performing the stepping operation;
to be configured to perform the calculation operation, the frequency hopping circuit is configured to calculate a difference number (df1) between the input number and the first divisor number;
to be configured to perform the decision operation, the frequency hopping circuit is configured to determine whether the convergence condition is satisfied; and
whether the convergence condition is satisfied relates to whether a number of times that a historical trend of a sign of the difference number shows a limit cycle during iterations of the calculation operation.

4. The clock circuit of claim 1 or 2, wherein:
whether the convergence condition is satisfied relates to whether an absolute difference between the input number and the first divisor number is less than a threshold value.

5. The clock circuit of claim 4, wherein:
each of the first divisor number and the threshold value is a non-integer value;
the frequency hopping circuit is configured to represent the first divisor number and the threshold value by two binary values of a same number of bits; and
a least significant bit of the binary value which represents the threshold value equals one, and remaining bits of the binary value which represents the threshold value equal zero.

6. The clock circuit of anyone of claims 1 to 5, wherein:
the frequency hopping circuit is further coupled to a hopping enabling signal (fh_en); and
the frequency hopping circuit is configured to perform the stepping operation if the hopping enabling signal equals a predefined logic value (ca1) and the convergence condition is not satisfied; and
the frequency hopping circuit is further configured to cause the first divisor number to equal the input number if the hopping enabling signal does not equal the predefined logic value.

7. The clock circuit of anyone of claims 1 to 6, wherein:
to be configured to perform the stepping operation, the frequency hopping circuit is configured to cause the current value to equal the previous value minus a step value (rg_ms) if the input number is less than the previous value, and is configured to cause the current value to equal the previous value plus the step value if the input number is greater than the previous value.

8. The clock circuit of anyone of claims 1 to 7, wherein:
the frequency hopping circuit is configured to perform the stepping operation during a period (T1) of an internal clock (sdm_ck);
to be configured to perform the frequency division according to the first divisor number, the frequency divider is configured to perform the frequency division according to a sum of the first divisor number and a second divisor number (ramp2);
the second divisor number periodically varies between a lower bound value (vL0) and an upper bound value (vH0); and
a period (Tss1) during which the second divisor number varies is longer than the period of the internal clock.

9. The clock circuit of anyone of claims 1 to 8, wherein:
the clock circuit further comprises a spread spectrum circuit (110) and a summing circuit (120);
the summing circuit is coupled among the spread spectrum circuit, the frequency hopping circuit and the frequency divider;
the spread spectrum circuit is configured to provide the second divisor number; and
the summing circuit is configured to calculate the sum of the first divisor number and the second divisor number.

10. The clock circuit of anyone of claims 1 to 9, wherein:
the clock circuit further comprises a sigma delta modulator (130) coupled between the frequency divider and the frequency hopping circuit;
the sigma delta modulator is configured to perform a sigma delta modulation on a sum (ramp_out) of the first divisor number and a second divisor number (ramp2), and accordingly generate a modulated divisor number (sdm1); and
to be configured to perform the frequency division according to the first divisor number, the frequency divider is configured to perform the frequency division according to the modulated divisor number.

11. The clock circuit of anyone of claims 1 to 10, wherein:
the frequency hopping circuit comprises a first multiplexer (m1), a second multiplexer (m2) and an internal control circuit (103);
the first multiplexer comprises two input terminals, an output terminal and a selection terminal respectively coupled to a first node (n1), a sixth node (n6), a second node (n2) and a fifth node (n5);
the second multiplexer comprises two input terminals, an output terminal and a selection terminal respectively coupled to the first node, the second node, a third node (n3) and a fourth node (n4);
the internal control circuit comprises two input terminals and two output terminals respectively coupled to the first node, a seventh node (n7), the fifth node and the sixth node;
the first node is further coupled to the input number (fra_in);
the fourth node is further coupled to a hopping enabling signal (fh_en);
the internal control circuit is configured to check whether the convergence condition is satisfied, and accordingly provide a hopping ready signal (fh_rdy) at the fifth node;
if the convergence condition is not satisfied, the internal control circuit is further configured to calculate an internal number (s1) outputted to the sixth node;
the first multiplexer is configured to selectively couple one of the first node and the sixth node to the second node according to a logic value of the hopping ready signal;
the second multiplexer is configured to selectively couple one of the first node and the second node to the third node according to a logic value of the hopping enabling signal; and
the frequency hopping circuit is configured to provide the first divisor number at the seventh node according to a signal at the third node.

12. The clock circuit of claim 11, wherein:
the frequency hopping circuit further comprises a flipflop (1062); and
the flipflop comprises an input terminal, an output terminal and a clock terminal respectively coupled to the third node, the seventh node and an internal clock (sdm_ck).

13. The clock circuit of claim 12, wherein:
the frequency hopping circuit further comprises a front multiplexer (m0) and a front flipflop (1061);
the front multiplexer comprises two input terminals, an output terminal and a selection terminal respectively coupled to a source number (fra0), the first node, a front node (n0) and a synchronized indication signal (chg_sync);
the front flipflop comprises an input terminal, an output terminal and a clock terminal respectively coupled to the front node, the first node and an internal clock (sdm_ck); and
the front multiplexer is configured to selectively couple one of the source number and the first node to the front node according to a logic value of the synchronized indication signal.

14. The clock circuit of anyone of claims 1 to 13, wherein:
when the clock circuit is requested to cause the frequency of the clock to hop from the first frequency to the second frequency, the clock circuit is configured to stabilize the frequency of the clock to the second frequency after an interval (Da1); and
during the interval, operations of the frequency hopping circuit, including the stepping operation, are configured to cause the frequency of the clock not to fall after rising.

15. The clock circuit of anyone of claims 1 to 14, wherein:
to be configured to perform the frequency division according to the first divisor number, the frequency divider is configured to perform the frequency division according to a sum of the first divisor number and a second divisor number (ramp2);
the clock circuit further comprises a spread spectrum circuit (110) for providing the second divisor number;
when the clock circuit is requested to cause the frequency of the clock to hop from the first spread spectrum range to the second spread spectrum range, the clock circuit is configured to cause the frequency of the clock to steadily spread over the second spread spectrum range after a second interval (Db1); and
during the second interval, the spread spectrum circuit is configured to keep on enabling a spread spectrum function which comprises varying the second divisor number.
